Europäisches Patentamt

European Patent Office

Office européen des brevets

(11) Numéro de publication: **0 333 166**
**A1**

## (12) DEMANDE DE BREVET EUROPEEN

(21) Numéro de dépôt: 89104594.0

(22) Date de dépôt: 15.03.89

(51) Int. Cl.⁴: **H01Q 25/00 , H01Q 3/26 , H03F 3/60**

(30) Priorité: 18.03.88 FR 8803547

(43) Date de publication de la demande:
**20.09.89 Bulletin 89/38**

(84) Etats contractants désignés:
**AT BE CH DE FR GB IT LI NL SE**

(71) Demandeur: **ALCATEL ESPACE**
**11, avenue Dubonnet**
**F-92407 Courbevoie Cédex(FR)**

(84) **DE FR GB IT SE**

Demandeur: **ALCATEL N.V.**
**Strawinskylaan 535**
**NL-1077 XX Amsterdam(NL)**

(84) **BE CH LI NL AT**

(72) Inventeur: **Lenormand, Régis**
**7 bis rue Pargaminières**
**F-31000 Toulouse(FR)**
Inventeur: **Billand, Marcel**
**route des Plauzaulles**
**F-31410 Noe(FR)**
Inventeur: **Fraise, Pierre**
**40 bis Avenue des Pyrénées**
**F-31270 Frouzins(FR)**
Inventeur: **Goupil, Jean-Claude**
**7 rue des Hortensias**
**F-31830 Plaisance du Touch(FR)**
Inventeur: **Raguenet, Gérard**
**2868 Route de Plantaurel Labarthe sur Leze**
**F-31120 Portet sur Garonne(FR)**
Inventeur: **Rene, Didier**
**30 avenue Pierre Molette**
**F-31100 Toulouse(FR)**

(74) Mandataire: **Weinmiller, Jürgen et al**
**Lennéstrasse 9 Postfach 24**
**D-8133 Feldafing(DE)**

(54) Antenne à reconfiguration électronique en émission.

(57) La présente invention se rapporte à une antenne à reconfiguration électronique en émission comprenant un réseau (11) de sources élémentaires, caractérisée en ce qu'elle comprend un réflecteur (10) focalisant l'énergie, le réseau (11) étant situé dans la zone focale de ce réflecteur, une électronique d'alimentation et de commande comprenant un étage d'amplification (22), constitué d'amplificateurs (24), dans lequel au moins un coupleur généralisé est disposé en sortie des amplificateurs (24), et des

circuits (20, 21) de formation de faisceau correspondant chacun à un faisceau émis, l'amplitude et la phase relative des signaux sortant de ces circuits étant contrôlés respectivement par un déphaseur réglable et un atténuateur réglable.

# FIG.1

## Antenne a reconfiguration électronique en émission

L'invention se rapporte à une antenne à reconfiguration électronique en émission.

Un ouvrage intitulé "télécommunications spatiales" de la collection technique et scientifique des télécommunications notamment dans son tome I pages 92 à 94 et pages 259 à 261 (Masson, 1982) décrit d'une part le fait de grouper plusieurs antennes, alimentées simultanément par le même émetteur avec interposition de diviseurs de puissances et de déphaseurs, les caractéristiques de rayonnement de ce groupement dépendant à la fois du diagramme de chaque antenne et de la répartition des puissances en amplitude et phase. Cette propriété est mise à profit pour obtenir un diagramme qui ne pourrait pas être obtenu avec une seule source rayonnante. Si en outre on modifie les caractéristiques des diviseurs de puissance et des déphaseurs par des moyens électroniques, on peut obtenir une modification quasi instantanée du diagramme. Le groupement le plus simple de sources rayonnantes est le réseau, dans lequel toutes les sources sont identiques et se déduisent l'une de l'autre par une translation quelconque. On peut donc avoir en particulier des réseaux rectilignes ou plans.

Ce document décrit, d'autre part, l'utilisation d'antennes à réflecteur pour la génération de faisceaux multiples, qui présentent l'avantage d'un faible poids et des possibilités de réalisation de grandes surfaces de rayonnement en utilisant des structures déployables. On fait généralement appel à ce type d'antennes lorsque l'on veut engendrer un ou plusieurs faisceaux étroits. En général le système d'illumination du réflecteur est décentré par rapport à celui-ci de façon à éviter tout blocage de l'ouverture rayonnante. En effet, un blocage de cette ouverture se traduit par un accroissement du niveau des lobes secondaires, ce qu'il faut à tout prix éviter dans ce genre d'application. Le réflecteur principal est par exemple un paraboloïde. Les faisceaux multiples sont obtenus en plaçant un ensemble de sources d'illumination au voisinage du foyer, chaque source correspondant à un faisceau. Du fait qu'on ne peut pas les placer exactement au foyer, l'illumination n'est pas géométriquement parfaite et il se produit des aberrations de phase qui dégradent quelque peu les performances de rayonnement. On observe une déformation du diagramme de rayonnement, des baisses de gain par rapport aux valeurs réalisables au foyer, et des lobes secondaires parasites. Ces dégradations sont d'autant plus importantes que l'on s'écarte du foyer et que la courbure du réflecteur est importante. On doit donc réaliser des réflecteurs aussi "plats" que possible, c'est-à-dire avec un rapport distance focale à diamètre d'ouverture élevé. Ceci conduit à des structures de dimensions importantes qui posent des problèmes de précision et de tenue mécanique. De plus, il peut exister entre les différentes sources des couplages mutuels parasites qui créent des lobes secondaires supplémentaires.

Etant donné que la diversité de polarisation ne peut être utilisée (du fait des problèmes de chemins multiples dans la bande des 1,6 Ghz (Bande L)), la seule solution est celle de la réutilisation de fréquence (particulièrement parce qu'il y a une limitation rigoureuse de largeur de bande pour les utilisateurs des télécommunications par satellite). La faisabilité d'un tel système dépend donc de la possibilité d'emploi d'une antenne en réutilisation de fréquence. Une autre nécessité, d'un point de vue système, est la possibilité pour l'antenne de s'adapter aux fluctuations dans la localisation de la demande de service. Cela conduit à utiliser une antenne à couverture reconfigurable.

L'invention a pour objet de répondre à cette nécessité.

L'invention propose à cet effet une antenne à reconfiguration électronique en émission comprenant un réseau de sources élémentaires, caractérisé en ce qu'elle comprenant un réflecteur focalisant l'énergie, le réseau étant situé dans la zone focale de ce réflecteur, et une électronique d'alimentation et de commande comprenant :

- m circuits de formation de faisceau qui synthétisent m faisceaux ;
- un étage d'amplification qui reçoit les sorties de ces circuits de formation combinées par l'intermédiaires de combineurs, cet étage d'amplification comprenant des amplificateurs en parallèles suivis d'un coupleur généralisé ;
- un circuit de commutation qui relie les sorties de l'étage amplificateur aux éléments rayonnants du réseau.

La solution proposée est du type balayage électronique. Elle est constituée d'un réseau réalisant la synthèse du champ électromagnétique dans la zone focale d'un réflecteur.

En plus de l'avantage d'une configuration compacte, d'une facilité de contrôle thermique, la simplicité d'ajustement de l'amplitude et de la phase des signaux appliqués aux résultats permet :
- de changer la direction du faisceau (pour la reconfiguration) et de compenser les aberrations dues au déplacement du réflecteur par rapport à la source ;
- d'obtenir des formes de radiation d'antennes à faibles lobes latéraux (réutilisation de fréquence) et de varier la forme des faisceaux.

Les caractéristiques et avantages de l'invention ressortiront d'ailleurs de la description qui va suivre, à titre d'exemple non limitatif, en référence aux figures annexées sur lesquelles :

     - la figure 1 illustre schématiquement l'antenne à balayage selon l'invention ;

     - la figure 2 illustre le fonctionnement de l'antenne selon l'invention ;

     - les figures 3 et 4 illustrent une réalisation d'une électronique de commande de l'antenne selon l'invention.

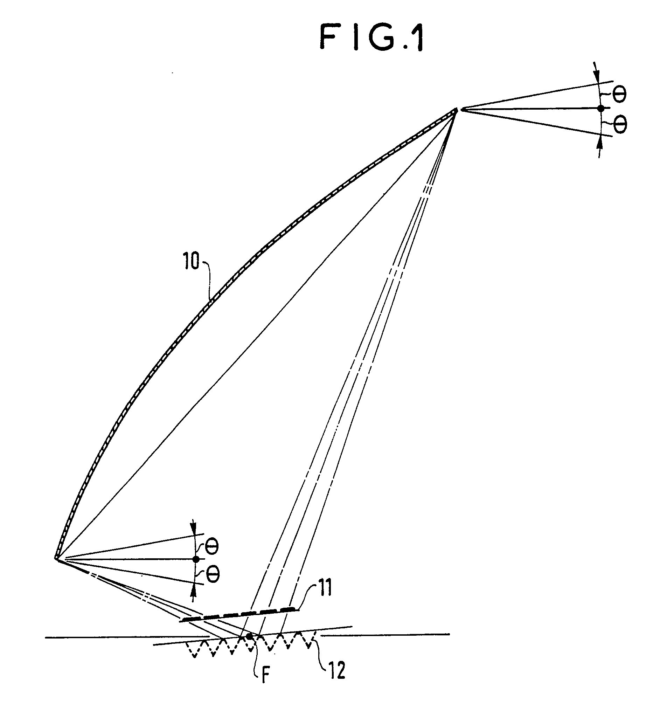

L'antenne de l'invention, représentée à la figure 1, comprend un réflecteur parabolique 10 excentrée alimenté par un réseau plan 11 de sources situé au voisinage du foyer F du réflecteur, le réseau 12 représentant le réseau de sources virtuelles, correspondant à ce réseau 11.

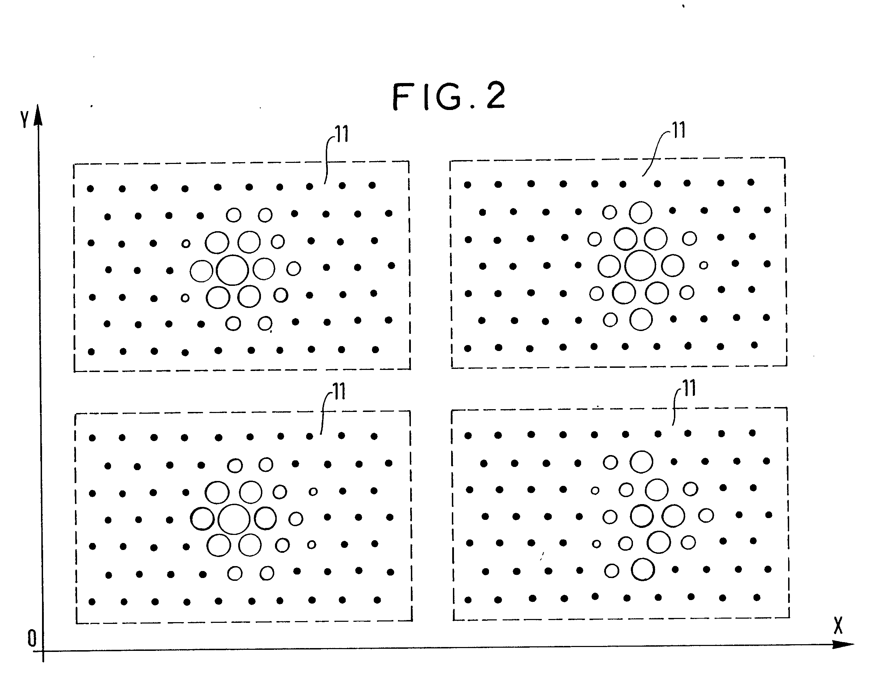

La figure 2 donne un exemple de plusieurs répartition en amplitude lors de déplacements selon deux directions OX et OY au niveau du réseau 11 de sources.

Les diamètres des disques portés sur à la figure 2 représentent l'amplitude du signal émis par les différentes sources du réseau.

L'efficacité pour émettre ces différentes répartitions d'énergie lorsque le capteur a une loi de répartition fixe, ne peut être optimale. Il en est de même pour la répartition en phase.

Ainsi si l'on déplace fictivement une source par rapport au foyer F du réflecteur on dégrade le rendement de l'antenne.

Dans l'antenne selon l'invention, on joue sur l'amplitude et sur la phase de chaque source élémentaire ; ce qui permet de réaliser la synthèse optimale de chaque source élémentaire comme si elle était au foyer F du réflecteur.

Un tel fonctionnement permet de réaliser une antenne dont le gain ne dépend pas de la direction de pointage, tout en maintenant fixe le réflecteur et le réseau de sources élémentaires.

Il est, difficile de sommer des faisceaux d'amplitudes et de phase différentes, sans entrainer de pertes.

Si on effectue la sommation avant amplification pour obtenir le ou les faisceaux que l'on veut synthétiser, on va obtenir une charge variable sur les amplificateurs, ce qui ne permet plus d'obtenir :

- une amplification linéaire (la dynamique du signal en entrée étant importante) ;

- un gain constant (la dynamique du signal en entrée étant importante) ;

On est alors obligé de surdimensionner la chaîne électronique d'émission ce qui conduit à une surconsommation de puissance.

Dans la suite de la description on considère deux faisceaux F1 et F2, mais il est bien évident que l'invention est tout aussi valable avec un nombre n de faisceaux Fj.

Pour obtenir une charge des amplificateurs qui soit constante, quelle que soit la position des faisceaux F1 et F2, l'invention propose l'utilisation d'au moins un coupleur généralisé qui permet de se rapprocher au mieux des conditions optimales de fonctionnement, chaque amplificateur ayant un rendement optimal lorsqu'il travaille à son point de fonctionnement optimal.

L'invention permet d'optimaliser la charge utile en terme de consommation.

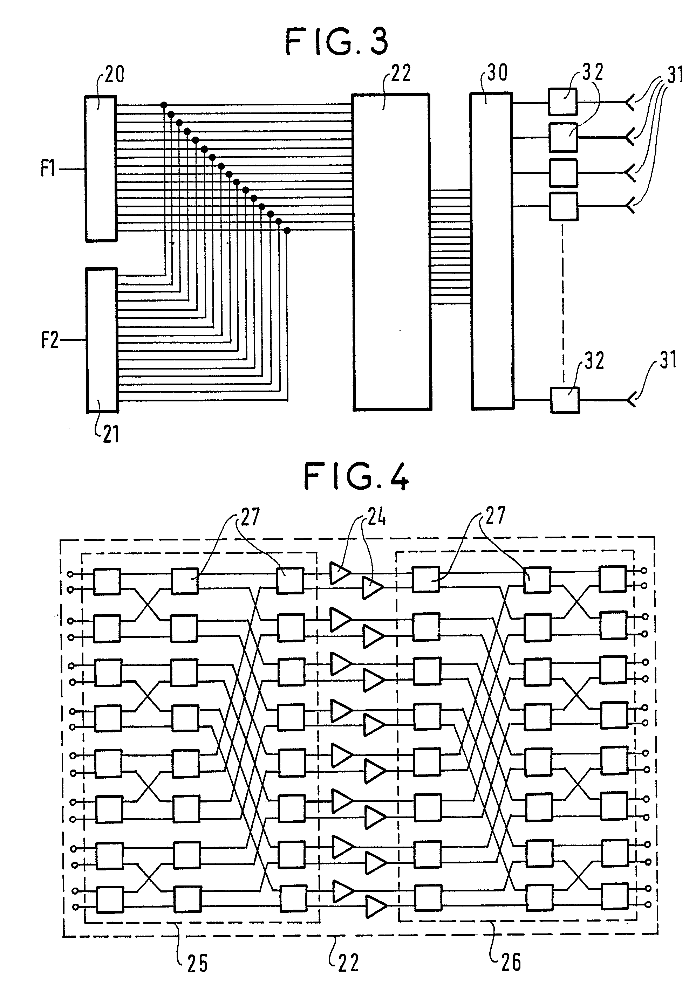

La configuration, représentée à la figure 1, comprenant un réflecteur et un réseau permet de générer un faisceau avec un gain quasi-constant dans n'importe quelle direction sur un large champ d'émission. L'électronique d'alimentation et de commande d'une telle antenne est représentée à la figure 3.

Sur cette figure deux circuits de formation de faisceaux 20 et 21 synthétisent deux faisceaux.

Chacun de ces circuits 20 et 21 a, ici, 16 sorties, l'amplitude et la phase relative des signaux sortant de ces circuits étant contrôlés par 16 déphaseurs réglables et 16 atténuateurs réglables contenus dans ces circuits 20 et 21.

Les 2 x 16 sorties de ces circuits sont reliés deux à deux aux 16 entrées de l'étage d'amplification 22 par l'intermédiaire de 16 combineurs qui ne sont pas représentés sur la figure.

Dans l'étage d'amplification 22 un signal appliqué à la première entrée, par exemple, ressort amplifié sur la première sortie.

Un schéma détaillé de l'étage d'amplification 22 est représenté à la figure 4.

Les amplificateurs de puissance 24 reçoivent sur leurs entrées respectives un signal provenant de chaque faisceau, à un niveau quasi-identique.

Selon l'invention on peut utiliser un seul coupleur généralisé 26 disposé en sortie des amplificateurs 24.

Avantageusement on intercale un premier 25 et un second 26 coupleurs généralisés respectivement formés d'une association de coupleurs hybrides 27 de part et d'autre des amplificateurs 24 de telle façon que chaque entrée du premier coupleur soit répartie sur tous les amplificateurs et donc sur toutes les sorties des coupleurs hybrides 27 du premier coupleur généralisé 25.

On obtient unr répartition de charge quasi-uniforme sur toutes les entrées des amplificateurs 24. On reconstitue ensuite les signaux à l'aide du deuxième coupleur généralisé 26 qui a une structure inverse de celle du premier, on retrouve les niveaux correspondant à chaque faisceau ici au nombre de deux ; F1 et F2.

Une telle réalisation optimise le fonctionnement de l'étage d'amplification.

Chaque amplificateur est alimenté par des composantes provenant des deux faisceaux F1 et F2 de telle façon qu'un changement dans le trafic n'a aucun impact sur le niveau du signal d'entrée appliqué aux amplificateurs, dans le cas où le trafic global reste constant.

Comme représenté sur la figure 3 un circuit de commutation 30 (pour la reconfigurabilité) relie les 16 sorties de l'étage d'amplificateur 22 aux n éléments rayonnants 31 du réseau, par l'intermédiaire de filtres 32.

De façon à reconfigurer les faisceaux, on modifie les caractéristiques d'amplitude et de phase appliqués aux éléments rayonnants, ainsi que la position de ces éléments rayonnants.

Ces caractéristiques amplitude, phase sont ajustés à l'aide d'atténuateurs variables et de déphaseurs variables contenus dans les circuits de formation de faisceaux 20 et 21. La position des éléments rayonnants est sélectionnée par le circuit de commutation 30.

Dans une variante de réalisation, des déphaseurs variables, non représentés sur les figures sont disposés respectivement en sortie des formateurs de faisceau 20, 21 et en sortie du deuxième coupleur généralisé 26.

Il est bien entendu que la présente invention n'a été décrite et représentée qu'à titre d'exemple préférentiel et que l'on pourra remplacer ses éléments constitutifs par des éléments équivalents sans, pour autant, sortir de cadre de l'invention.

**Revendications**

1/ Antenne à reconfiguration électronique en émission comprenant un réseau (11) de source élémentaires, caractérisée en ce qu'elle comprend un réflecteur (10) focalisant l'énergie, le réseau (11) étant situé dans la zone focale de ce réflecteur, et une électronique d'alimentation et de commande comprenant :
- m circuits de formation de faisceau (20, 21) qui synthétisent m faisceaux ;
- un étage d'amplification (22) qui reçoit les sorties de ces circuits de formation combinées par l'intermédiares de combineurs, cet étage d'amplification comprenant des amplificateurs (24) en parallèles suivis d'un coupleur généralisé (26) ;
- un circuit de commutation (30) qui relie les sorties de l'étage amplificateur (22) aux éléments rayonnants (31) réseau.

2/ Antenne selon la revendication 1, caractérisé en ce que l'électronique de commande et d'amplification comprend un premier (25) et un second (26) coupleurs généralisés disposés de part et d'autre des amplificateurs (24), le second coupleur généralisé (26) ayant une structure inverse de celle du premier (25).

3/ Antenne selon la revendication 1, caractérisé en ce que chaque circuit de formation de faisceau comprend des déphaseurs réglables et des atténuateurs réglables de manière à contrôler l'amplitude et la phase relative de chacun de ses signaux de sortie.

4/ Antenne selon la revendication 1, caractérisé en ce que des filtres (32) sont disposés respectivement entre les sorties de l'étage amplificateur (22) et les éléments rayonnants (31) du réseau.

# FIG.1

FIG.2

# FIG. 3

# FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | R.C.A. REVIEW, vol. 46, no. 3, septembre 1985, pages 375-392, Princeton, New Jersey, US; S.H. COLODNY et al.: "Active-array antenna beam shaping for direct broadcast satellites and other applications" * Figure 1; pages 376-378, paragraphe: "Introduction" * --- | 1-3 | H 01 Q  25/00 H 01 Q   3/26 H 03 F   3/60 |
| Y | FR-A-2 570 883  (NIPPON TELEGRAPH TELEPHONE) * En entier * --- | 1-3 | |
| A | FR-A-2 368 836  (MATRA) * En entier * --- | 1,4 | |
| A | FR-A-2 241 886  (L.C.T.) * En entier * --- | 1 | |
| A | IEEE INTERNATIONAL CONFERENCE ON COMMUNICATIONS 1985, Chicago, Illinois, 23-26 juin 1985,  · "Communications-Facilitating the knowledge revolution", Conference Record, vol. 3, pages 1299-1305, IEEE; S.V. PAREKH et al.: "Active antennas for satellite communications" --- | | DOMAINES TECHNIQUES RECHERCHES (Int. Cl.4)  H 01 Q H 03 F |
| A | US-A-4 477 781  (M.L. REUSS, Jr.) ----- | | |

Le présent rapport a été établi pour toutes les revendications

| Lieu de la recherche | Date d'achèvement de la recherche | Examinateur |
|---|---|---|
| LA HAYE | 07-06-1989 | CHAIX DE LAVARENE C.P.H. |